# EUROPÄISCHE PATENTSCHRIFT

(11) **EP 0 977 337 B1**
(45) Veröffentlichungstag und Bekanntmachung des Hinweises auf die Patenterteilung: **09.03.2011**
(21) Anmeldenummer: 99113966.8
(22) Anmeldetag: 17.07.1999
(51) Int. Cl.: H02H 7/12, G01R 19/25

(54) **Schaltungsanordnung zur Messung und Begrenzung von Strömen in Umrichtern zur Speisung von Motoren**
Circuit for measuring and limiting currents in converters for supplying motors
Circuit de mesure et de limitation des courants dans des convertisseurs pour l'alimentation des moteurs

(30) Priorität: 30.07.1998 DE 19834315
(43) Veröffentlichungstag der Anmeldung: 02.02.2000
(73) Patentinhaber: Diehl AKO Stiftung & Co. KG, 88239 Wangen im Allgäu (DE)
(72) Erfinder: Weinmann, Martin, Dipl.-Ing. (FH), 88339 Bad Waldsee (DE)
(74) Vertreter: Diehl Patentabteilung

(56) Entgegenhaltungen:
- WO-A1-96/23347
- US-A- 5 278 747
- US-A- 5 373 195
- PATENT ABSTRACTS OF JAPAN Bd. 1998, Nr. 11, 30. September 1998 (1998-09-30) & JP 10 150775 A (TOSHIBA CORP), 2. Juni 1998 (1998-06-02)
- PATENT ABSTRACTS OF JAPAN Bd. 017, Nr. 460 (E-1419), 23. August 1993 (1993-08-23) & JP 05 103494 A (TOSHIBA CORP), 23. April 1993 (1993-04-23)

## Beschreibung

Die vorliegende Erfindung betrifft ein Verfahren mit darauf aufbauender Schaltungsanordnung zur Messung der Ströme eines aus einem Spannungszwischenkreis gespeisten Umrichter zur Ansteuerung von Motoren, bei der mit einem Meßmittel zur Strommessung sowohl die Phasenströme des Motors als auch die Stromaufnahme aus dem Netz gemessen werden können nach Anspruch 1, sowie eine Schaltungsanordnung zur Einschaltstrombegrenzung nach Anspruch 2.

Um aus einem Umrichter gespeiste Motoren, wie Asynchronmotoren oder Synchronmotoren, unter allen Betriebsbedingungen, wie beispielsweise Drehmoment, Drehzahl und Motortemperatur, elektrisch so zu speisen, daß der Motor mit dem höchstmöglichen Wirkungsgrad betrieben wird, ist es erforderlich, daß die elektrische Steuerung zur Speisung des Motors als Reglereingangsgröße auch über die Meßgröße der Phasenströme des Motors verfügt. Hierdurch kann dann zum Beispiel auch eine feldorientierte Regelung des Motors implementiert werden.

Eine Schaltungsanordnung zur aktiven Leistungsfaktorkorrektur (PFC), d.h. zur gesteuerten Stromaufnahme aus dem Netz nach Stand der Technik ist z.B. auf Seite 49, Bild 1, in Heft 23/1996 der Zeitschrift "ELEKTRONIK", Franzis-Verlag, veröffentlicht. Der entsprechende Strommeßwiderstand zur Messung der Netzstromaufnahme befindet sich dort in der Netzzuleitung.

Schaltungsanordnungen zur Einschaltstrombegrenzung nach Stand der Technik sind z.B. im Datenbuch: Heißleiter, Siemens Matsushita Components, 1996, Seite 36, Bild 10 oder im Datenbuch von Thomson-CSF LCC, 1994, Seite 28, Bild 16 zu entnehmen. Diesen Schahungsanordnungen ist gemeinsam, daß ein temperaturabhängiger Widerstand (NTC) in der Netzzuleitung zum Zwischenkreis den Einschaltstrom bei Zuschaltung der Elektronik mit entladenen Zwischenkreiskondensator an das Netz begrenzt.

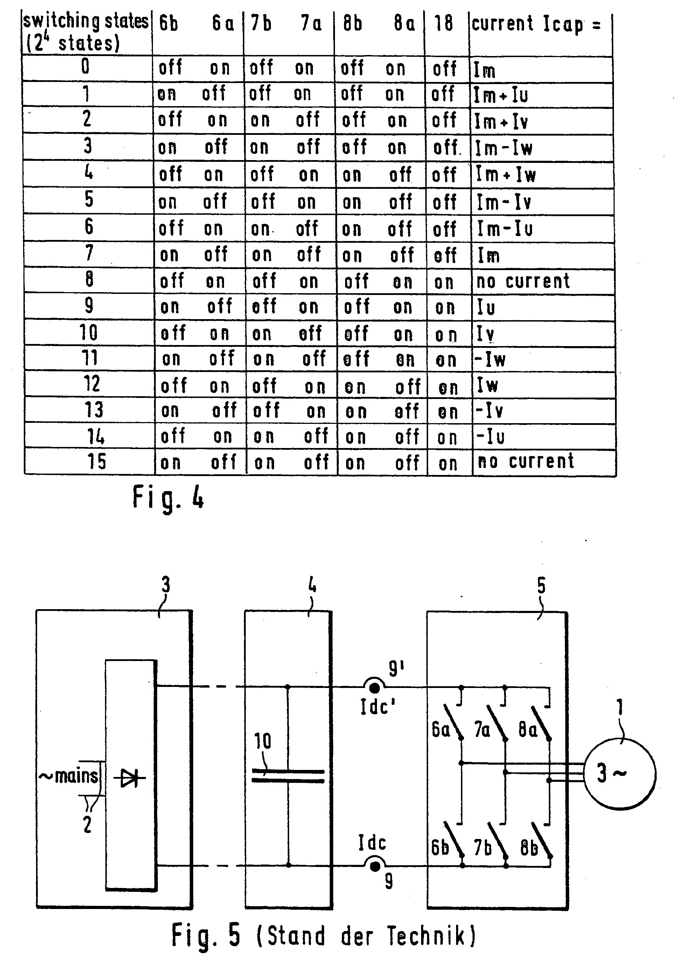

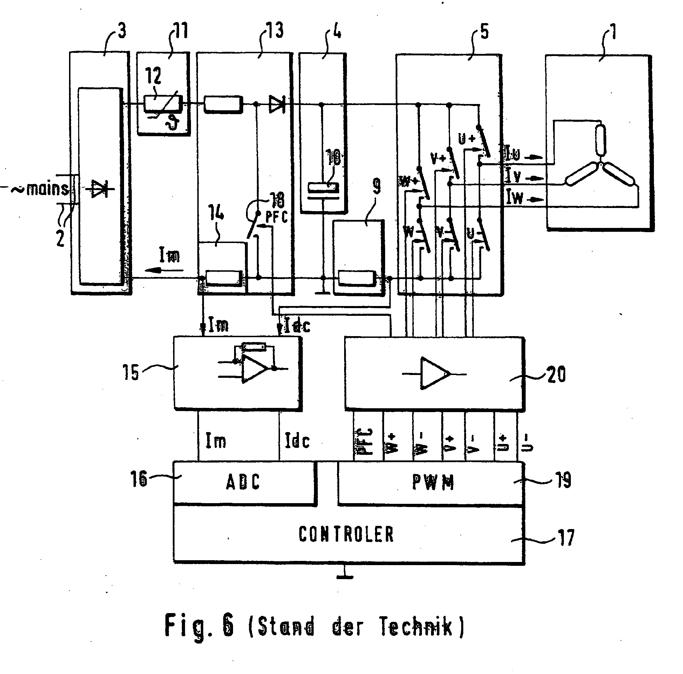

Eine herkömmliche Schaltungsanordnung zur Messung der Phasenströme eines aus einem 6-pulsigen Umrichter gespeisten dreiphasigen Motors, die z.B. aus den nachfolgend aufgeführten Publikationen bekannt ist, ist beispielhaft in den Figuren 5 und 6 gezeigt. In Figur 5 ist zunächst schematisch die vereinfachte Topologie eines aus einem Spannungszwischenkreis 4 gespeisten Umrichters 5 zur Speisung eines dreiphasigen Motors 1 dargestellt. Die Nachladeeinrichtung für den Zwischeakreiskondensator 10 des Spannungszwischenkreises 4 besteht zum Beispiel aus einer am Niederspannungsnetz 2 angeschlossenen Gleichrichterbrücke 3. Der 6-pulsige Umrichter 5 weist drei obere Schaltmittel 6a, 7a, 8a und drei unter Schaltmittel 6b, 7b, 8b auf, welche beispielsweise durch Leistungstransistorenrealisiert sind. Die Schaltmittel 6-8 bilden dabei drei Schaltmittel-Halbbrücken 6a-6b, 7a-7b und 8a-8b, die jeweils invers angesteuert werden, so daß - bei Vernachlässigung der Schalttotzeiten - von jeder Halbbrücke zu jedem Zeitpunkt jeweils ein Schaltmittel geöffnet und das entsprechende andere Schaltmittel geschlossen ist.

Zwischen Spannungszwischenkreis 4 und Umrichter 5 ist wahlweise ein Mittel 9 oder 9' zur Strommessung geschaltet, welches der Messung des Umrichterstromes Idc bzw. alternativ Idc' im Spannungszwischenkreis 4 dient. Nach dem in Figur 5 veranschaulichten Stand der Technik erfolgt die Strommessung im Spannungszwischenkreis 4 in einem Strompfad, in dem ausschließlich der Umrichterstrom Idc, Idc' fließt.

Eine Schaltungsanordnung, wie sie in dieser Figur 5 dargestellt ist, ist zum Beispiel in der WO 96/23347 A1 offenbart.

In der Publikation "Deviation of Motor Line-Current Waveforms from the DC-Link Current of an Inverter" von T.C. Green und B.W. Williams, IEE Proceedings Part B, Vol. 136, No. 4, Juli 1989, Seiten 196 - 204, wird beschrieben, wie durch die Messung des Umrichterstromes Idc im Spannungszwischenkreis 4 und dessen Zuordnung zu den Schaltzuständen der Schaltmittel 6-8 des Umrichters 5 die Phasenströme des Motors 1 rekonstruiert werden können. Als kostengünstigste Lösung für das Strommeßmittel 9, 9' wird dort ein Meßwiderstand mit Signalverstärkung mittels schnellem Operationsverstärker im Spannungszwischenkreis 4 vorgeschlagen, wobei der Meßwiderstand in einem Strompfad vorgesehen ist, in dem ausschließlich der Umrichterstrom Idc fließt (siehe Figur 2, Seite 197 dieser Veröffentlichung).

Weiter wird auch in der Publikation "Phase Current Reconstruction of a Three-Phase Voltage Source Inverter Fed Drive Using a Sensor in the DC-Link" von M. Riese von der Technischen Universität Dresden, Intelligent Motion '96 - Mai, Proceedings, CD-Version, Seiten 95-102, ein Verfahren zur Rekonstruktion der Phasenströme eines dreiphasigen Motors erläutert. Hier werden die Phasenströme des Motors ebenfalls aus einer Strommessung in einem Pfad des Spannungszwischenkreises abgeleitet, in dem ausschließlich der Umrichterstrom fließt (siehe Picture 1 der Veröffentlichung).

In Figur 6 ist nun die vollständige Topologie der in Figur 5 dargestellten herkömmlichen Elektronik veranschaulicht. Ganz links in Figur 6 ist die Gleichrichterbrücke 3 zur Gleichrichtung der Wechselspannung bei Speisung der Elektronik aus dem Niederspannungsnetz 2 gezeigt. Der positive Ausgang der Gleichrichterbrücke 3 ist mit einem Einschaltstrombegrenzer 11 verbunden, der zum Beispiel aus einem NTC-Widerstand 12 zur Begrenzung der Stromaufnahme der angeschlossenen Elektronik bei Netzzuschaltung bei entladenem Zwischenkreiskondensator 10 besteht. An die Gleichrichterbrücke 3 ist ferner eine Einrichtung 13 zur aktiven Steuerung der Stromaufnahme auf dem Netz 2 zur Leistungsfaktorkorrektur (PFC) in der Topologie eines Hochsetzstellers angeschlossen. Der gezeigte Hochsetzsteller 13 weist zudem ein Mittel 14 zur Messung des Netzstromes in Form eines Meßwiderstandes auf. Dieser Meßwiderstand 14 kann allerdings nicht so groß gewählt werden, daß der Einschaltstrombegrenzer 11 entfallen könnte, da die Verlustleistung bei Einsatz eines geeigneten Festwiderstandes in der Netzzuleitung zu groß wäre.

An den Hochsetzsteller 13 schließt sich der schon anhand von Figur 5 erläuterter Spannungszwischenkreis 4 mit beispielsweise einem Hochspannungs-Elektrolyt-Kondensator 10 an. Das Strommeßmittel 9 ist in einem Strompfad des Spannungszwischenkreises 4 angeordnet, in dem ausschließlich der Umrichterstrom Idc fließt. Der Spannungszwischenkreis 4 speist den Umrichter 5, der als 6-pulsige Brücke für den dreiphasigen Motor 1 ausgebildet ist. Als Schaltmittel 6-8 des Umrichters 5 werden nach dem Stand der Technik zum Beispiel Leistungstransistoren, wie IGBT's, mit antiparallel geschalteten Freilaufdioden eingesetzt.

Ein analoger Treiberbaustein 15 verstärkt die an den beiden Meßwiderständen 9 und 14 abgegriffenen Meßsignale so, daß die Meßsignale Im (Netzstrom) und Idc (Umrichterstrom) durch einen Analog/Digital-Wandler 16 einer Steuervorrichtung 17, wie beispielsweise eines Microcontrollers, mit ausreichender Auflösung ausgewertet werden können. Der Microcontroller 17 steuert und regelt sowohl den Motor 1 über die Schaltmittel 6-8 des Umrichters 5 als auch die Stromaufnahme aus dem Niederspannungsnetz 2 über das Schaltmittel 18 des Hochsetzstellers 13. Die Schaltmittel 6-8 und 18 werden dabei beispielsweise von einer PWM-(Pulsbreiten-Modulations-)Einheit 19 mit Hilfe eines digitalen Leistungstreiberbausteines 20 gesteuert.

Die JP 10 150775 A zeigt eine Schaltungsanordnung zum Ansteuern eines Drehstrommotors. Die Phasenströme werden durch unmittelbar in den Stromleitungen zwischen dem Umrichter und dem Motor angeordneten Strommessmitteln gemessen.

Die US 5,278,747 zeigt eine Schaltungsanordnung für z.B. einen Motor. In Reihe zu einem Zwischenkreiskondensator ist ein niederohmiger Messwiderstand angeordnet.

Ausgehend von dem oben anhand der Figuren 5 und 6 beschriebenen Stand der Technik ist es Aufgabe der vorliegenden Erfindung, eine Vorrichtung zur Messung der Ströme eines aus einem Umrichter gespeisten Motors vorzuschlagen, welche nicht nur die Messung der Motorströme ermöglicht, sondern mit der auch die Netzstromaufnahme gemessen und begrenzt werden kann.

Diese Aufgabe wird durch ein Verfahren mit den Merkmalen von Anspruch 1 gelöst.

Die Messung des Stromes in einem Strompfad, in dem ausschließlich der Strom Icap der Kapazität des Spannungszwischenkreises fließt, hat gegenüber der Messung des Umrichterstromes Idc verschiedene Vorteile. Es kann mit dem Strommeßmittel neben der Strommessung der Phasenströme des Motors auch der aufgenommene Netzstrom gemessen werden, was zumindest bei einer aktiven Steuerung der Stromaufnahme aus dem Netz notwendig ist, so daß im Gegensatz zu herkömmlichen Verfahren kein zweites Strommeßmittel für die Messung des Netzstromes eingesetzt werden muß. Durch des erfindungsgemäße Verfahren wird somit die Schaltungsanordnung vereinfacht und demnach auch kostengünstiger.

Ein weiterer wesentlicher Vorteil des erfindungsgemäßen Verfahrens besteht darin, daß das Strommeßmittel zur Messung des Stromes Icap in der Kapazität des Spannungszwischenkreises gleichzeitig als Einschaltstrombegrenzer bei entladenem Zwischenkreiskondensator wirkt, wenn das Strommeßmittel in Form eines elektrischen Widerstandes ausgebildet ist. Hierdurch ist es möglich, auf einen zusätzlichen Widerstand zur Einschaltstrombegrenzung am Ausgang der Gleichrichterbrücke zu verzichten. Wenn sich gemäß der erfindungsgemäßen Schaltungsanordnung der Widerstand zur Einschaltstrombegrenzung also nicht in der Netzzuleitung, sondern in Reihe mit dem Zwischenkreiskondensator befindet, wo die effektive Strombelastung typisch um den Faktor 2 geringer ist, womit sich die Verlustleistung am Einschaltstrombegrenzer bei gleichem Widerstandswert etwa auf ¼ gegenüber der herkömmlichen Anordnung reduziert, kann beispielsweise anstelle eines teureren temperaturabhängigen Widerstandes ein Festwiderstand verwendet werden.

Weitere Ausgestaltungen und Weiterbildungen der vorliegenden Erfindung sind Gegenstand der Unteransprüche.

Die Erfindung wird im folgenden anhand eines bevorzugten Ausführungsbeispieles unter Bezugnahme auf die beiliegende Zeichnung näher erläutert. Darin zeigen:
- Figur 1: schematisch die vereinfachte Topologie eines aus einem Umrichter ge- speisten mehrphasigen Motors zur Durchführung der vorliegenden Erfindung;
- Figur 2: die Schaltungsanordnung von Figur 1 zusätzlich mit einem Mittel zur aktiven Steuerung der Stromaufnahme aus dem Netz (PFC);
- Figur 3: schematisch die vollständige Topologie eines aus einem Umrichter ge- speisten mehrphasigen Motors zur Durchführung der vorliegenden Erfindung;
- Figur 4: eine Tabelle der möglichen Schaltzustände der Schaltmittel und des zu- gehörigen gemessenen Stromes der Schaltungsanordnung von Figur 2 bzw. 3;
- Figur 5: schematisch die vereinfachte Topologie eines herkömmlichen aus einem Umrichter gespeisten mehrphasigen Motors; und
- Figur 6: schematisch die vollständige Topologie eines aus einem Umrichter ge- speisten mehrphasigen Motors nach dem Stand der Technik.

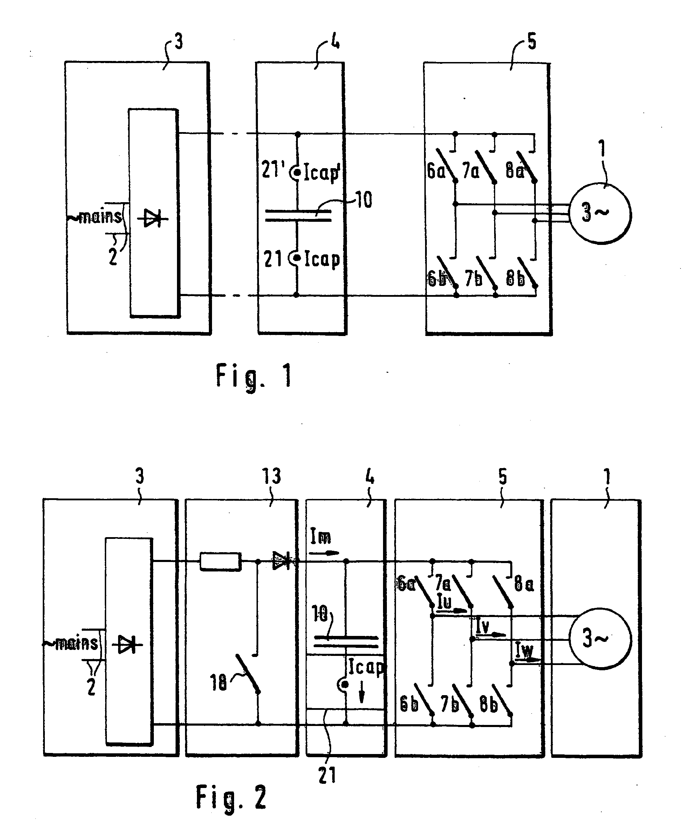

In Figur 1 ist zunächst eine vereinfachte Schaltungsanordnung zur erfindungsgemäßen Messung der Phasenströme Iu, Iv, Iw eines dreiphasigen Motors 1 dargestellt, der von einem 6-pulsigen Umrichter 5 betrieben wird. Der Umrichter 5 seinerseits wird aus einem Spannungszwischenkreis 4 gespeist, der im wesentlichen aus einem Zwischenkreiskondensator 10, vorzugsweise einem Hochspannungs-Elektrolyt-Kondensator, aufgebaut ist. Die Nachladeeinrichtung für den Zwischenkreiskondensator 10 des Spannungszwischenkreises 4 besteht aus einer am Niederspannungsnetz 2 angeschlossenen Gleichrichterbrücke 3 bekannter Art.

Der 6-pulsige Umrichter 5 weist drei obere Schaltmittel 6a, 7a, 8a und drei unter Schaltmittel 6b, 7b und 8b auf, welche vorzugsweise durch Leistungstransistoren, wie beispielsweise IGBT's, mit antiparallel geschalteten Freilaufdioden realisiert sind. Die Schaltmittel 6-8 sind dabei als drei Schaltmittel-Halbbrücken 6a-6b, 7a-7b und 8a-8b geschaltet, die jeweils invers angesteuert werden, d.h. wenn das obere Schaltmittel 6a, 7a, 8a geschlossen ist, ist - bei Vernachlässigung der in der Praxis auftretenden Schalttotzeiten - das entsprechende untere Schaltmittel 6b, 7b und 8b geöffnet und umgekehrt.

Zur Messung der Phasenströme Iu, Iv, Iw des Motors 1 ist ein Mittel 21 bzw. 21' zur Strommessung vorgesehen, welches in einem Strompfad angeordnet ist, in dem ausschließlich der Strom Icap bzw. Icap' der Kapazität 10 des Spannungszwischenkreises 4 - im folgenden nur kurz Kondensatorstrom Icap bezeichnet - fließt. Vorzugsweise ist das Mittel 21, 21' zur Strommessung direkt in Reihe mit dem Zwischenkreiskondensator 10 geschaltet. Die in Figur 1 gezeigten Strommeßmittel 21 und 21' werden alternativ verwendet. Als Strommeßmittel 21, 21' eignen sich beispielsweise einfache Meßwiderstände.

In Figur 2 ist die Schaltungsanordnung von Figur 1 dargestellt, welche um einen sogenannten Hochsetzsteller 13 zur Leistungsfaktorkorrektur (PFC) erweitert ist. In dieser Schaltungsanordnung wirkt sich die erfindungsgemäße Anordnung des Strommeßmittels 21 besonders günstig aus.

Zwischen den Spannungszwischenkreis 4 und der Gleichrichterbrücke 3 ist ein Mittel zur aktiven Steuerung der Stromaufnahme aus dem Niederspannungsnetz 2 geschaltet, das in der Topologie eines Hochsetzstellers 13 dargestellt ist. Ein solcher Hochsetzsteller dient der Leistungsfaktorkorrektur (PFC) zur Einhaltung entsprechender EMV-Vorschriften bezüglich Netzoberwellen. Der Hochsetzsteller 13 weist, parallel zu dem Zwischenkreiskondensator 10 geschaltet, ein Schaltmittel 18 auf, welches - wie die Schaltmittel 6-8 des Umrichters 5 - von einer in Figur 2 nicht gezeigten Steuervorrichtung 17 gesteuert wird, um die Stromaufnahme der Schaltungsanordnung zu steuern. In diesem Fall hängt der momentane Strom Icap im Zwischenkreiskondensator 10 zusätzlich noch von dem momentanen Schaltzustand des Schaltmittels 18 ab.

Mit Hilfe dieses Hochsetzstellers 13 kann die Wechselstrombelastung für den Zwischenkreiskondensator 10 des Spannungszwischenkreises 4 maßgeblich reduziert werden, da die Stromaufnahme aus dem Netz 2 dem vom Umrichter 5 angeforderten Strom angenähert werden kann. Hierdurch ist es möglich, das Strommeßmittel 21 des Kondensatorstromes Icap als einfachen induktionsarmen Festwiderstand auszubilden. Dieses wirkt vorzugsweise zugleich als Mittel zur Einschaltstrombegrenzung bei Zuschaltung des Umrichters 5 mit entladendem Zwischenkreiskondensator 10 an das Netz 2, so daß bei der erfindungsgemäßen Anordnung des Strommeßmittels 21 auf einen zusätzlichen Widerstand zur Einschaltstrombegrenzung am Ausgang der Gleichrichterbrücke 3 verzichtet werden kann.

Anstelle einer entsprechenden Dimensionierung des Widerstandes 21 als Festwiderstand ist es im Rahmen der vorliegenden Erfindung auch denkbar, ihn als Reihenschaltung aus Festwiderstand zur Strommessung sowie eines weiteren Widerstandes zur Einschaltstrombegrenzung vorzusehen. Dieser zusätzliche Widerstand kann beispielsweise ein temperaturabhängiger NTC-Widerstand sein. Die oben genannten Vorteile bezüglich der verminderten Verlustleistung gelten bei dieser alternativen Schaltungsanordnung entsprechend.

Der Hochsetzsteller 13 umfaßt im Gegensatz zum Stand der Technik kein Strommeßmittel zur Messung des Netzstromes Im, da dieser Netzstrom Im erfindungsgemäß ebenfalls durch die Strommessung des Kondensatorstromes Icap gemessen werden kann, wie weiter unten noch erläutert werden wird.

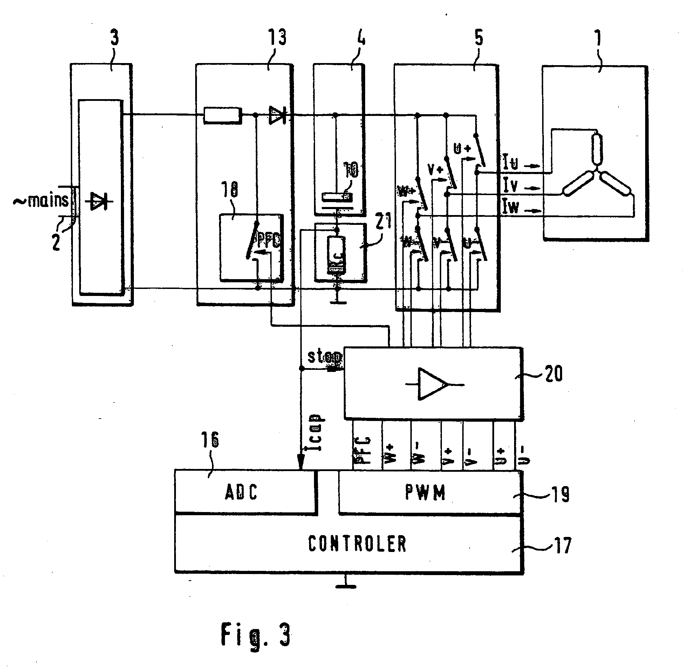

Die vollständige erfindungsgemäße Topologie der Elektronik zur Ansteuerung eines dreiphasigen Motors 1 ist in Figur 3 gezeigt. Die Schaltungsanordnung weist wie die Schaltungsanordnung von Figur 2 eine aktive Steuerung der Stromaufnahme aus dem Netz 2 zur Leistungsfaktorkorrektur auf. Die Baugruppen Gleichrichterbrücke 3, Hochsetzsteller 13, Spannungszwischenkreis 4 und Umrichter 5 entsprechen den bereits oben anhand der Figuren 1 und 2 beschriebenen Baugruppen, weshalb an dieser Stelle auf eine nähere Beschreibung verzichtet werden soll.

Die Steuervorrichtung 17, beispielsweise ein Microcontroller, steuert und regelt sowohl den Motor 1 über die Schaltmittel 6-8 als auch die Stromaufnahme aus dem Niederspannungsnetz 2 über das Schaltmittel 18. Der Microcontroller 17 kann das Meßsignal Icap des Meßwiderstandes 21 direkt über seinen Analog/DigitalWandler 16 auswerten. Auf eine analoge Treiberstufe zur Vorverstärkung des Meßsignales Icap kann hierbei verzichtet werden, da die Strombelastung für den Meßwiderstand 21 bei der erfindungsgemäßen Schaltungsanordnung geringer ist als bei der herkömmlichen Schaltungsanordnung gemäß Figur 6 (Meßwiderstand 14), und somit der Widerstandswert des Meßwiderstandes 21 so groß gewählt werden kann, daß der A/D-Wandler 16 des Microcontrollers 17 das Meßsignal Icap auch ohne Vorverstärkung mit ausreichender Auflösung auswerten kann. Sowohl die Schaltmittel 6-8 des Umrichters 5 als auch das Schaltmittel 18 des Hochsetzstellers 13 werden vom Microcontroller 17 über eine Modulations-Einheit 19 mit Hilfe eines digitalen Leistungstreiberbausteines 20 gesteuert. Als Modulations-Einheit 19 wird zum Beispiel eine PWM-(Pulsbreiten-Modulations-) Einheit oder wahlweise eine Delta-Modulations-Einheit verwendet.

Im Fall von hohen Schaltfrequenzen der Schaltmittel 6-8, 18 wird im allgemeinen die sogenannte natürliche PWM eingesetzt. Im wesentlichen wird bei diesem Verfahren der Arbeitszyklus einer Rechteck-Wellenform fester Frequenz mit der Magnitude einer Sinuswelle moduliert. Gleichzeitig wird die Ansteuerung der Schaltmittel synchronisiert, wobei hierzu verschiedene Möglichkeiten bekannt sind. Eine detaillierte Beschreibung der Modulations-Möglichkeiten findet sich zum Beispiel in der oben genannten Publikation von T.C. Green und B.W. Williams.

Bei Überschreitung einer bestimmten Spannungsreferenz am Meßwiderstand 21, d.h. bei Überstrom, kann ferner die Leistungsstufe 20 unmittelbar (→stop) abgeschaltet werden. Dabei können für positive und negative Überströme unterschiedliche Grenzwerte definiert sein. Bei einem solchen Abschalten der Leistungsstufe 20 werden vorzugsweise die Motorklemmen des Motors 1 automatisch kurzgeschlossen, wie dies bei den Schaltzuständen 0, 7, 8 und 15 der unten erläuterten Tabelle von Figur 4 der Fall ist.

Figur 4 zeigt tabellarisch die möglichen Schaltzustände des 6-pulsigen Umrichters 5 zur Speisung eines dreiphasigen Motors 1 mit aktiver Steuerung 13 der Stromaufnahme aus dem Netz 2 nach der Schaltungsanordnung von Figur 2. Unter Vernachlässigung von Schalttotzeiten ergeben sich für die insgesamt vier Schaltmittel 6-8 und 18 insgesamt 2⁴ = 16 verschiedene Schaltzustände, die in der Tabelle von Figur 4 mit den Schaltzuständen 0 bis 15 gekennzeichnet sind.

Wie beispielsweise in der bereits eingangs genannten Veröffentlichung von T.C. Green und B.W. Williams näher erläutert, können die Schaltzustände der Schaltmittel 6-8, 18 mittels einer einfachen logischen Schaltung aus den sieben Steuersignalen U+, U-, V+, V-, W+, W- und PFC der PWM-Einheit 19 identifiziert werden. Aus der Symmetrie der Umrichterschaltung 5 ergibt sich, daß der Kondensatorstrom Icap zum Beispiel in den Schaltzuständen 10 und 13 nur vom Phasenstrom Iv bzw. in den Schaltzuständen 2 und 5 nur vom Phasenstrom Iv und dem Netzstrom Im abhängt. Der A/D-Wandler 16 erfaßt synchron zu den momentanen Schaltzuständen der Schaltmittel 6-8, 18 das Strommeßsignal Icap. Indem der Kondensatorstrom Icap und gleichzeitig die Schaltzustände der Schaltmittel im Augenblick der Strommessung erfaßt werden, kann der Verlauf der Phasenströme Iu, Iv, Iw des Motors 1 und des Netzstromes Im rekonstruiert werden.

Bei den Schaltzuständen 9 bis 14, d.h. bei geschlossenem Schalter 18 des Hochsetzstellers 13, fließt jeweils der Strom Iu, Iv, Iw einer Motorphase durch den Zwischenkreiskondensator 10. Beim Kurzschließen der Motorklemmen, d.h. bei fensteuerung (off) aller oberen Schaltmittel 6a-8a (Schaltzustand 15) oder bei Offensteuerung aller unteren Schaltmittel 6b-8b (Schaltzustand 8), fließt kein Kondensatorstrom Icap. Wird bei kurzgeschlossenen Motorklemmen das Schaltmittel 18 des Hochsetzstellers 13 geöffnet, so fließt über den Zwischenkreiskondensator 10 der Netzstrom Im. Bei den Schaltzuständen 1 bis 6, d.h. bei geöffnetem Schalter 18, fließt sowohl der Netzstrom Im als auch der Motorstrom Iu, Iv, Iw einer Motorphase über den Zwischenkreiskondensator 10.

Im Falle einer Schaltungsanordnung ohne Leistungsfaktorkorrektur mittels Hochsetzsteller 13 reduzieren sich die Schaltzustände der Tabelle von Figur 4 auf die Schaltzustände 0 bis 7. Die Messung des momentanen Phasenstromes Iu, Iv, Iw erfolgt dann durch eine Differenzmessung zwischen dem Summenstrom Netzstrom Im + Phasenstrom Iu, Iv, Iw (Schaltzustände 1 bis 6) und dem Netzstrom Im (Schaltzustände 0 und 7).

## Patentansprüche

1. Verfahren zur Strommessung bei einem aus einem Spannungszwischenkreis (4) gespeisten Umrichter (5),
wobei zur Strommessung durch die den Umrichter (5) steuernde, elektrische Steuerung (17) der Kondensatorstrom (Icap) im Spannungszwischenkreis gemessen wird, und durch Zuordnung des momentanen Strom-Meßwertes zu einem momentanen Schaltzustand von Leistungsschaltern (6...8) des Umrichters (5) bzw. eines Schalters zur Steuerung der Stromaufnahme (18) aus dem Netz (2) der Verlauf der Phasenströme in mindestens einer der Motorphasen (U,V,...) eines ein- oder mehrphasigen Motors (1) bzw. der Verlauf der Stromaufnahme (Im) aus dem Netz rekonstruiert wird,
**dadurch gekennzeichnet,**
**daß** in unmittelbarer Serie mit einem Kondensator (10) des Spannungszwischenkreises (4) ein Mittel zu Strommessung (21) geschalten wird, über das genau und ausschließlich der Kondensatorstrom (Icap) fließt.

2. Verfahren nach Anspruch 1,
**dadurch gekennzeichnet,**
**daß** das Mittel zur Strommessung (21) aus einem elektrischen ohmschen Festwiderstand besteht, in dem der Spannungsabfall an demselben das Meßsignal für den Kondensatorstrom (Icap) liefert.

3. Verfahren nach Anspruch 2,
**dadurch gekennzeichnet,**
**daß** der Spannungsabfall über dem Festwiderstand in Reihe mit dem Zwischenkreiskondensator unmittelbar ohne analoge Vorverstärkung (15) durch die aus einem Microcontroller oder DPS bestehende Steuervorrichtung (17) gemessen wird.

4. Verfahren nach Anspruch 1,
**dadurch gekennzeichnet,**
**daß** der Widerstand (21) in Reihe zum Kondensator (10) des Spannungszwischenkreises (4) aus einer Reihenschaltung aus Festwiderstand zur Strommessung sowie einem temperaturabhängigen Widerstand (NTC) zur zusätzlichen Einschaltstrombegrenzung besteht.

5. Schaltungsanordnung zur Durchführung des Verfahrens nach einem der Ansprüche 1 bis 4.

## Claims

1. Method for measuring current in a converter (5) which is powered from a voltage intermediate circuit (4),
wherein for the purpose of current measurement the electrical controller (17) controlling the converter (5) measures the capacitor current (Icap) in the voltage intermediate circuit, and association of the instantaneous measured current value with an instantaneous switching state of circuit breakers (6 ... 8) in the converter (5) or in a switch for controlling the current draw (18) from the mains (2) reconstructs the profile of the phase currents in at least one of the motor phases (U, V, ...) of a single-phase or polyphase motor (1) or the profile of the current draw (Im) from the mains,
**characterized**
**in that** a means for measuring current (21) is connected in direct series with a capacitor (10) of the voltage intermediate circuit (4) and carries precisely and exclusively the capacitor current (Icap).

2. Method according to Claim 1,
**characterized**
**in that** the means for measuring current (21) comprises an electrical non-reactive fixed resistor in which the voltage drop across the latter provides the measurement signal for the capacitor current (Icap).

3. Method according to Claim 2,
**characterized**
**in that** the voltage drop across the fixed resistor in series with the intermediate circuit capacitor is measured directly without analogue preamplification (15) by the control apparatus (17), which comprises a microcontroller or DPS.

4. Method according to Claim 1,
**characterized**
**in that** the resistor (21) in series with the capacitor (10) of the voltage intermediate circuit (4) comprises a series circuit containing a fixed resistor for measuring current and a temperature-dependent resistor (NTC) for additionally limiting the switch-on current.

5. Circuit arrangement for carrying out the method according to one of Claims 1 to 4.

## Revendications

1. Procédé de mesure du courant sur un convertisseur (5) alimenté à partir d'un circuit intermédiaire de tension (4),
selon lequel la mesure du courant est réalisée en mesurant le courant de condensateur (Icap) dans le circuit intermédiaire de tension par l'intermédiaire de la commande électrique (17) qui commande le convertisseur (5) et le tracé des courants de phase dans au moins l'une des phases de moteur (U, V, ...) d'un moteur (1) à une ou plusieurs phases ou le tracé du courant consommé (Im) depuis le réseau est reconstruit en affectant la valeur mesurée momentanée du courant à un état de commutation momentané des commutateurs de puissance (6, ..., 8) du convertisseur (5) ou d'un commutateur destiné à commander le courant consommé (18) depuis le réseau,
**caractérisé en ce**
**qu'**un moyen de mesure du courant (21), par lequel circule précisément et exclusivement le courant du condensateur (Icap), est branché directement en série avec un condensateur (10) du circuit intermédiaire de tension (4).

2. Procédé selon la revendication 1, **caractérisé en ce que** le moyen de mesure du courant (21) se compose d'une résistance fixe ohmique électrique dans laquelle la chute de tension aux bornes de celle-ci fournit le signal de mesure pour le courant du condensateur (Icap).

3. Procédé selon la revendication 2, **caractérisé en ce que** la chute de tension aux bornes de la résistance fixe en série avec le condensateur de circuit intermédiaire est mesurée directement sans préamplification analogique (15) par le dispositif de commande (17) constitué d'un microcontrôleur ou d'un DSP.

4. Procédé selon la revendication 1, **caractérisé en ce que** la résistance (21) en série avec le condensateur (10) du circuit intermédiaire de tension (4) se compose d'un circuit série constitué d'une résistance fixe pour la mesure du courant et d'une résistance dépendante de la température (CTN) destiné à une limitation supplémentaire du courant de mise en circuit.

5. Arrangement de circuit pour mettre en oeuvre le procédé selon l'une des revendications 1 à 4.
